# NEW EUROPEAN PATENT SPECIFICATION

(11) **EP 0 768 538 B2**
(45) Date of publication and mention of the opposition decision: **01.10.2014**
(45) Mention of the grant of the patent: 12.01.2000
(21) Application number: 96202805.6
(22) Date of filing: 09.10.1996
(51) Int. Cl.: G01R 31/3185, G06F 11/267, G11C 29/00

(54) **Method and tester for applying a pulse trigger to a unit to be triggered**
Verfahren und Tester zur Beaufschlagung eines elektronischen Bausteins mit einem Triggerimpuls
Procédé et testeur pour la délivrance des implusions de déclenchement à une unité

(30) Priority: 13.10.1995 EP 95202758
(43) Date of publication of application: 16.04.1997
(73) Proprietor: JTAG Technologies B.V., 5602 AN Eindhoven (NL)
(72) Inventor: De Wit, Hendrikus, c/o Int. Octrooibureau B.V., 5656 AA Eindhoven (NL); Stork, Cornelis F.J.M., c/o Int.Octrooibureau B.V., 5656 AA Eindhoven (NL)
(74) Representative: Algemeen Octrooi- en Merkenbureau B.V.

(56) References cited:
- EP-A- 0 402 134
- US-A- 5 448 575
- ELECTRONIC DESIGN, vol. 41, no. 4, February 1993, CLEVELAND, OH, pages 61-73, XP000349033 COLEMAN J. ET AL.: "Boundary Scan speeds static memory tests"
- PATENT ABSTRACTS OF JAPAN vol. 18, no. 478 (P-1796) & JP-A-06 160489 (HITACHI LTD.), 6 July 1994,

## Description

The invention relates to a method of applying a pulse trigger to a unit to be triggered, the pulse trigger being applied to the unit to be triggered under the control of Boundary Scan Test (BST) logic.

A unit to be triggered is to be understood to mean herein a unit which executes an operation only after having received an appropriate signal, the so-called pulse trigger. A pulse trigger of this kind has a given dynamic behavior. It may be, for example, an edge at a transition from a given value to another given value, a pulse at which the signal changes its value and subsequently returns thereto again, or a pulse train involving various changes of the value. An example of a unit to be triggered is a memory which receives address information and data on appropriate pins and stores the data after the pulse trigger, being a write enable in the present case, has been applied to the relevant pin.

Boundary Scan Test (BST) is a method developed to assist the testing of Printed Circuit Boards and is laid down in a standard (IEEE Std. 1149.1 - 1990). The BST method is also described in U.S. Patent No. 5,430,735 (PHN 11.856). The publication "The ABCs of Boundary Scan Test", published by Philips Test & Measurement, Eindhoven, the Netherlands, describes the concept of the method and contains examples of its implementation. A method of the kind set forth is described on pages 161 to 166 of the book "Boundary-Scan Test, Practical Approach" by Harry Bleeker, Peter van den Eijnden and Frans de Jong, Kluwer, 1993, ISBN 0-7923-9296-5. These pages describe how a memory is tested by driving it by the BST chain with BST cells. According to the known method the pulse trigger, in that case being a write enable (WE) for the memory, is applied to the memory via the BST chain. Table 5-12 on page 163 of the cited book reveals that 3 vectors are required to apply the pulse trigger to the memory, i.e. the lines 4-6 of the table. A vector is a pattern of bits, each of which is placed in an appropriate BST cell. To this end, a vector must be serially shifted through the BST chain. In this case 3 vectors are required, because the pulse trigger must consist of the bits "1", "0" and "1". A BST chain consists of a potentially large number of BST cells; in that case many shift operations are required to apply the pulse trigger to the memory. It is a drawback of this method that the application of the pulse trigger is very time consuming.

A further method is known from JP-A-06 160489. In that document, a testing object, such as a Large Scale Integrated (LSI) circuit, is described, inside which Boundary Scan Test circuitry and a pulse generating circuit are located. The pulse generating circuit, in response to signals from the Boundary Scan circuitry, outputs a pulse signal with a prescribed pulse amplitude to the necessary internal sections of the testing object. In this way, only one vector needs to be shifted in and the time of input of the data can be reduced to 1/3 of the time in the past. The Boundary Scan Test circuitry and the pulse generating circuit are located inside the testing object, as otherwise it would be impossible to satisfy the delay time specifications of the testing object.

N. Münch et al.: "ASP 100-D/PROG User Manuel", printed 13/09/1994 describes an application in-circuit programming of a Unit Under Test, UUT, wherein the address lines are formed by B Scan devices on the UUT, the data lines and signal lines by Parallel Interface Ports, PIPs.

It is inter alia an object of the invention to provide a method of the kind set forth in which no measures have to be taken inside the testing object in order to make the method applicable. To this end, the invention provides a method as defined in claim 1. Because the pulse trigger is generated by the pulse circuit and not by the BST logic itself, the pulse trigger can be generated within a short period of time. The pulse circuit can independently generate the pulse trigger and need not do so in the form of cycles such as those in which the BST logic applies data to the unit. Furthermore, as the steps of the method are performed externally to the unit to be triggered, the method can be used in an assembly that was initially not conceived to generate a pulse trigger.

A preferred embodiment of the method in accordance with the invention is defined by claim 2. Thus the pulse circuit can be switched to a transparent mode by way of the enable input. In the transparent mode the circuit no longer generates the pulse trigger, but passes on the stimulus from the input to the output. The pulse circuit can thus be by-passed and the pulse trigger can be applied completely via the BST chain.

The pulse circuit can independently generate the pulse trigger in a shorter period of time than the BST logic itself. The pulse circuit need not generate the pulse trigger in the form of cycles such as those in which the BST logic applies data to the unit.

These and other aspects of the invention will be apparent from and elucidated with reference to the embodiments described hereinafter.

In the drawings:
Fig. 1 shows an arrangement for carrying out the invention;
Fig. 2 shows a number of signals relating to the pulse circuit upon use of a version of the method in accordance with the invention;
Fig. 3 shows an embodiment of the pulse circuit which is suitable for carrying out the method in accordance with the invention;
Fig. 4 shows an embodiment of the pulse circuit which comprises an enable input; and
Fig. 5 shows an alternative arrangement for carrying out the invention.

Corresponding reference numerals in the drawing denote identical or similar components.

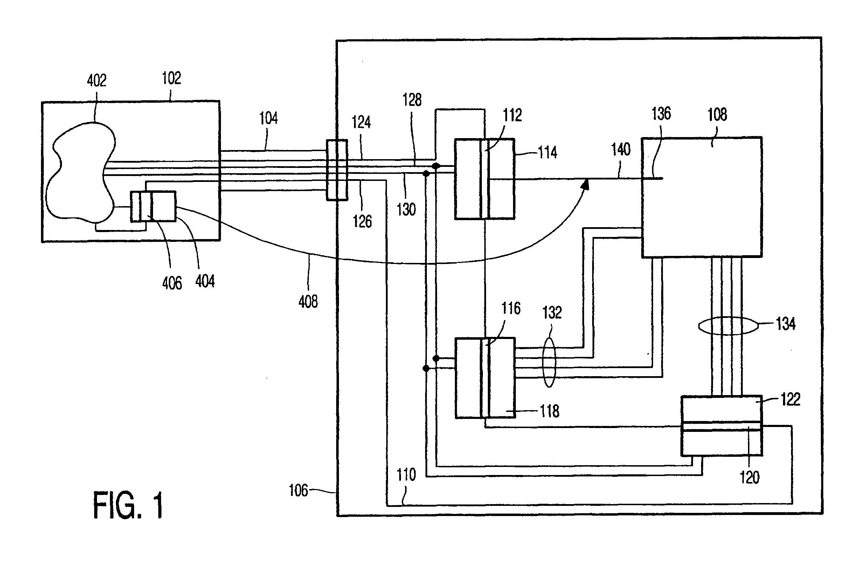

Fig. 1 shows an arrangement for carrying out the invention. Tester 102 is connected, via a connection 104, to a testing object or assembly 106, for example a Printed Circuit Board on which a unit 108 to be triggered is accommodated. The assembly 106 also comprises a BST chain 110 which comprises a BST register 112 of a component 114, a BST register 116 of a component 118, and a BST register 120 of a component 122. The connection point 124 to the tester is the so-called Test Data Input (TDI) and the connection point 126 is the Test Data Output (TDO). Furthermore, each component receives a Test Clock (TCK) signal via a point 128 and a Test Mode Select (TMS) signal via a point 130, both signals being supplied by the tester 102. A BST register of a component comprises a number of BST cells, each of which is coupled to a respective pin of the component. This coupling has been omitted in Fig. 1 for the sake of clarity. The components 114, 118 and 120 and the unit 108 to be triggered also have a given functionality. However, in the context of the present invention this functionality is not relevant so that it is omitted for the sake of clarity of Fig. 1. The significance of the BST signals and the function of the BST components are described in the cited publication "The ABCs of Boundary Scan Test". The tester shifts signals through the BST chain so as to reach given BST cells, after which these signals are presented, via connections 132 and 134, to the unit 108 to be triggered. However, in order to process these signals the unit 108 should receive a pulse trigger on input 136. An example in this respect is that the unit 108 concerns a memory which should receive a Write Enable signal in order to accept data presented, or that the unit 108 is a memory which should receive an Output Enable signal in order to output data present at a given address in the memory. There are also other examples of the use of such a pulse trigger for explicitly starting an operation in a unit to be triggered. The pulse trigger for the input 136 could be generated by shifting a number of successive bits, via the BST chain, to an appropriate BST cell of BST register 112, wherefrom they are presented to the input 136 via a connection 140. For given memories, a "1", a "0" and a "1" should be successively applied to the input 136 for a write operation in the memory; in that case three complete shift operations through the BST chain are required. The signal must be shifted through all BST cells in a BST chain, thus requiring a corresponding number of cycles of the tester. When this approach is used in practice, test periods as long as 3 minutes occur in the testing of memories.

The tester 102 comprises in addition to core logic 402, a pulse circuit 404 which is included in the BST chain. The pulse circuit is arranged to generate independently the pulse trigger required for the unit 108. The pulse circuit can be constructed in various ways, for example as a so-called one-shot circuit, as a single flip-flop, or as a state machine. In the arrangement shown in Fig. 1, the pulse circuit comprises a BST cell 406 and receives a stimulus for generating the pulse trigger from said BST cell 406. In the operational mode the input 136 of the unit 108 receives the pulse trigger from the component 114 via the connection 140. When the data is supplied via the BST chain, for example in order to execute a test, the pulse trigger can be supplied by the pulse circuit 404 via the connection 408. The connection 408 may be implemented as a detachable connection cord which can be brought into contact with the connection 140 by way of a pen. However, the connection 408 may also be designed so as to form part of the connection 104 between the tester 102 and the assembly 106.

The method is carried out as described above, the stimulus being shifted into the BST cell 406 and the actual pulse circuit subsequently generating the required pulse trigger which is applied to the input 136 via the connection 408. When the pulse trigger is applied in this manner, the output of the component 114 which presents the pulse trigger in the operational mode is de-activated so as to prevent competition on the relevant connection. To this end, said output is constructed as a tri-state output which can be switched to the high-impedance (high Z) mode so that another output can determine the value of the connection. A facility of this kind is described in the Boundary Scan Test standard. In this embodiment, where the pulse trigger consists of the bits "1", "0" and "1", two complete shift operations can be dispensed with in accessing the memory. In the described practical example the test period of the memory is reduced from 3 minutes to 1 minute. An advantage of the arrangement of Fig. 1 resides in the fact that it can be used in an assembly 106, for example a printed circuit board comprising several components, which was initially not conceived to generate the pulse trigger according to the method of the invention. When a further external connection 408 is provided, the pulse trigger can be generated, under the control of an appropriately designed tester 102, in the described manner. The assembly 106 itself need not be modified or provided with a further facility.

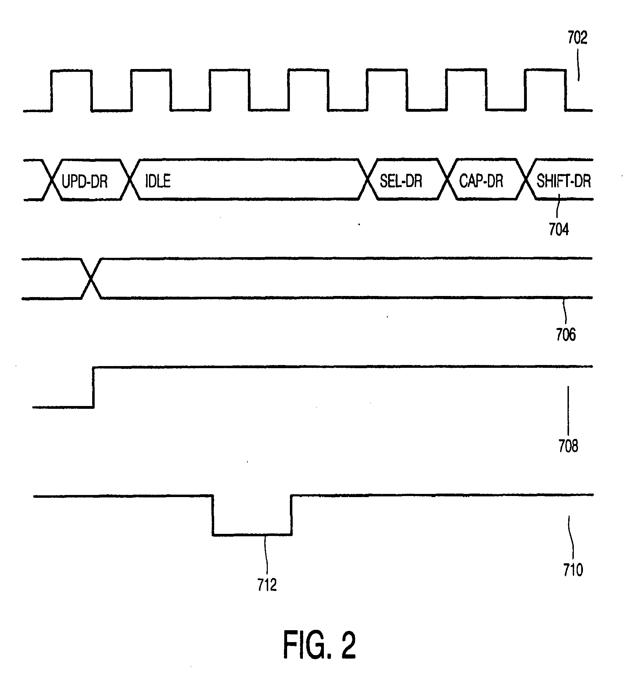

Fig. 2 shows a number of signals relating to the pulse circuit as they occur during execution of a version of the method in accordance with the invention. Signal 702 is the TCK signal of the BST logic and determines inter alia the instants at which the value of other signals may change. The reference 704 denotes a number of states of the TAP controller. The reference 706 indicates when the signals applied from the BST cells to the unit to be triggered are valid in time. The stimulus presented to the pulse circuit is denoted by the reference 708. The pulse trigger generated by the pulse circuit is represented by the line 710. The signals shown concern a pulse circuit which co-operates with the further BST logic which applies data to the unit to be triggered. This is only one of the feasible embodiments and, evidently, a different version will involve other signals. The pulse trigger shown is a so-called negative pulse trigger, because the actual pulse 712 is negative with respect to the remainder of the signal. It will be evident that the invention can also be used in the event of a positive pulse trigger. The signal is then inverted with respect to the signal 710 and the actual pulse is positive in comparison with the remainder of the signal. The invention can also be used in a pulse trigger of different form. This is the case, for example, in a situation in which it suffices that the input to be triggered receives a single transition from low to high or a single transition from high to low. However, the invention can also be used in situations in which the pulse trigger is a longer, more complex signal. The savings arise from the fact that the complete pulse trigger need no longer be transported to the input to be triggered via the BST chain, but that it suffices to apply a stimulus to a pulse circuit which subsequently generates the complete pulse trigger independently and without further shift operations being required.

In conformity with the method shown in Fig. 2, the state "UPDATE-DR" of the TAP controller serves as a start in the pulse circuit. However, another state could also be chosen, be it that the timing of said other state would differ from the timing shown.

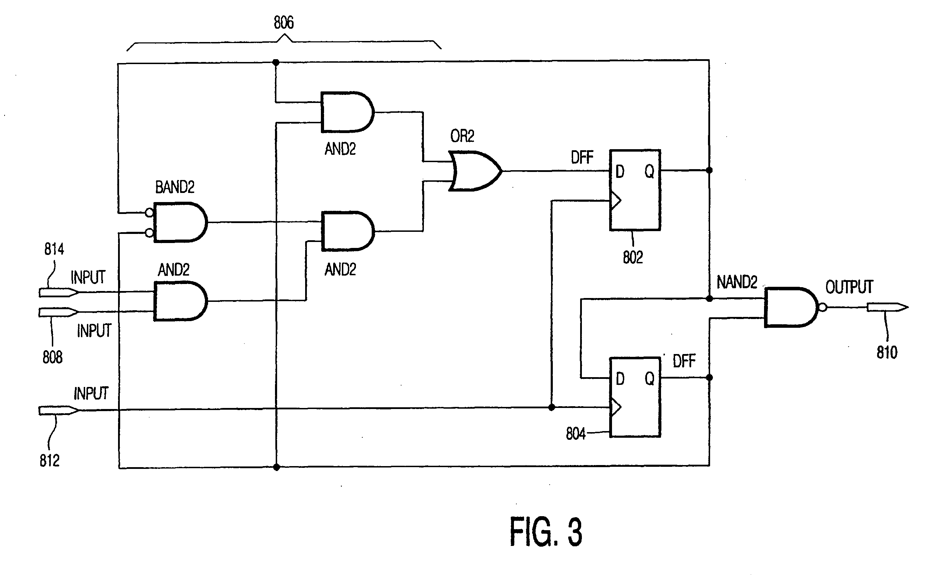

Fig. 3 shows an embodiment of the pulse circuit which is suitable for carrying out the method of the invention. This is a state machine comprising a flip-flop 802, a flip-flop 804 and combinatory logic 806. The circuit comprises an input 808 for receiving the stimulus and an output 810 for supplying the pulse trigger. The pulse circuit also comprises an input 812 for receiving the TCK signal, being the clock signal controlling the activities of the BST logic, and an input 814 for receiving the update signal, being the signal supplied by the TAP controller which indicates the updating of the BST registers. The TCK signal and the update signal together enable the pulse circuit to operate in combination with the other BST logic; for a further explanation in this respect reference is made to the cited publication "The ABCs of Boundary Scan Test". Under the control of the TCK signal, the outputs of the flip-flops, and hence the output of the pulse circuit, receive a repetition of values in conformity with the following table.

| Q (802) | Q (804) | Output (810) |
|---|---|---|
| 0 | 0 | 1 |
| 0 | 1 | 1 |
| 1 | 1 | 0 |
| 1 | 0 | 1 |

The series "1101" on the output 810 corresponds to the pulse trigger 710 in Fig. 2.

The pulse circuit of Fig. 3 can be included in a circuit which already comprises a TAP controller capable of supplying the update signal required. If the pulse circuit is constructed as a fully independent circuit, it should be provided with a TAP controller. Examples of such a fully independent circuit are specifically designed circuit on a printed circuit board and a component comprising the pulse circuit.

Fig. 3 shows an embodiment of a pulse circuit which can be used in accordance with the invention. However, a circuit of this kind can be constructed in various ways, the circuit then being capable of cooperating more or less with the BST logic. The pulse circuit can be constructed in such a manner that the BST signals TMS and TCK are not used in the circuit, for example as in a one-shot circuit. Circuits other than the circuit shown in Fig. 3 can be used in conformity with the invention.

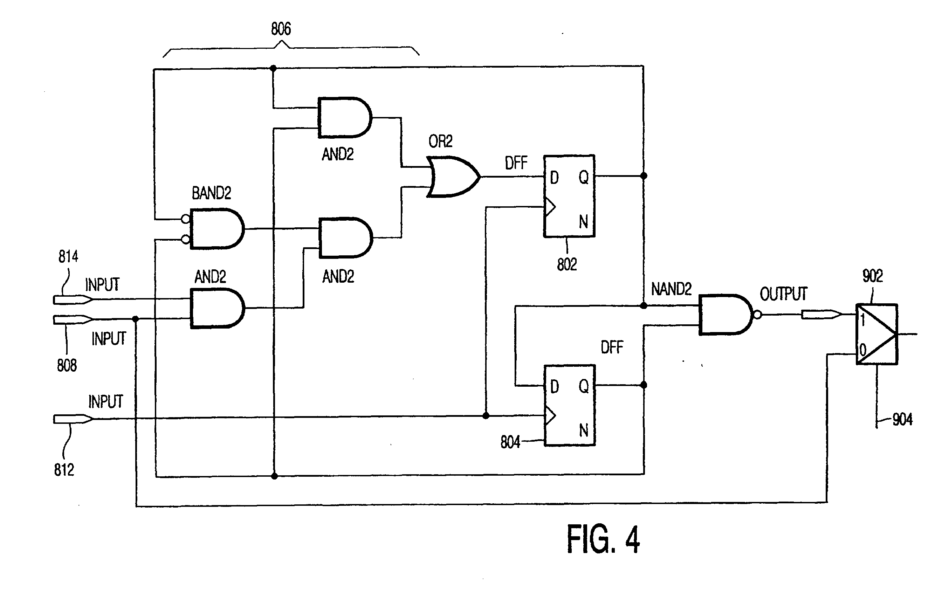

Fig. 4 shows an embodiment of the pulse circuit which comprises an enable input. This embodiment of the pulse circuit comprises a multiplexer 902 which is controlled by an enable signal on input 904. This embodiment of the pulse circuit can be switched to a transparent mode under the control of the enable signal. The multiplexer 902 is then switched so that no longer the output of the actual pulse circuit is applied to its output but the signal from the input 808. The enable signal can be supplied by a BST cell, so that the pulse circuit can be driven to a transparent mode via the BST chain.

In the context of the present invention the described tester is used inter alia for testing the unit 108. The unit 108 may be a memory in which, as part of the test, data is written and subsequently read again, after which the data read is compared with the original data. A complete test comprises a large number of such read/write test steps so that it is comparatively time consuming. A so-called Output Enable signal is required so as to read from a memory. This signal is comparable with the Write Enable which can be supplied as a pulse trigger by the pulse circuit in accordance with the invention. Therefore, the invention can be readily used for the Output Enable signal for memories. In a given embodiment of the invention the pulse trigger for writing into the memory and the pulse trigger for reading from the memory are generated by the same pulse circuit. The pulse circuit generates the second pulse trigger in dependence on the first pulse trigger and does not require a separate stimulus for this purpose. Because it is not necessary to supply a separate stimulus via the BST chain again a complete shift operation through the BST chain is saved during said write/read test step.

In addition to testing, however, the tester can also be used for programming a memory. In that case the program is written into the memory as data from the tester, via the BST chain. This is used inter alia for so-called flash memories.

A pulse circuit operating in cooperation with the further BST logic can be activated by various BST instructions. This may be one of the instructions "SAMPLE/PRELOAD" or "EXTEST" specified in the BST standard. However, it may also be activated by a private instruction added to the component. The BST standard allows a manufacturer of a component to provide, in addition to the set of specified instructions, a supplementary instruction having a given function.

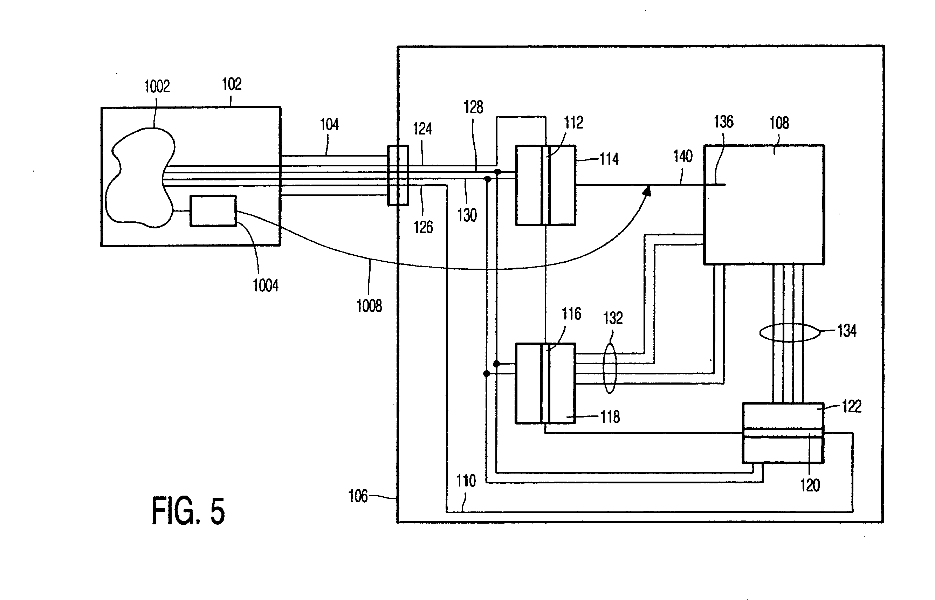

Fig. 5 shows an alternative of the tester comprising the pulse circuit. In addition to the core logic 1002 this embodiment of the tester 102 comprises a pulse circuit 1004. The pulse circuit is driven by the logic 1002 which generates the BST control signals, such as the TMS and TCK signals, for the assembly 106. In the operational mode the input 136 of the unit 108 receives the pulse trigger from the component 114 via the connection 140. When the data is supplied via the BST chain, for example in order to execute a test, the pulse trigger can be supplied by the pulse circuit 1004 via the connection 1008. The connection 1008 may be constructed as a detachable connection cord which is brought into contact with the connection 140 via a pen. However, the connection 1008 may also be constructed as part of the connection 104 between the tester 102 and the assembly 106. The method is carried out as described above, the pulse circuit generating, activated by the tester logic 1002, the required pulse trigger and applying it to the input 136 via the connection 1008. Activation can take place on the basis of a given instruction or command in the tester or on the basis of information in the memory of the tester. The memory controls the operation of the BST logic on the assembly 106 and, therefore, the pulse trigger can be given in relation to the operation of the components of the assembly. For example, first the data can be applied to the unit 108 via the connections 132 and 134, and subsequently the pulse trigger can be applied to the input 136. The circuit 114 which originally supplied the pulse trigger will be de-activated in the manner described with reference to Fig. 1. An advantage of the tester shown in Fig. 5 consists in that it can be used in an assembly 106, for example a printed circuit board comprising several components, which initially was not conceived to generate the pulse trigger in the manner of the invention. The pulse trigger can be generated by the described method of the invention by providing a further external connection 1008 and under the control of a tester 102 conceived for this purpose. The assembly 106 itself need not be modified or provided with a further facility.

## Claims

1. A method of applying a pulse trigger to a unit (108) that is to be triggered during a Boundary Scan of an electronic circuit (106) carried out by Boundary Scan Test logic and which electronic circuit (106) comprises the unit (108), the method comprising the steps of:
determining a state in Boundary Scan Test logic in which the pulse trigger can be generated;
activating a pulse circuit (404; 806; 1004) by the Boundary Scan Test logic in response to said state; and
generating the pulse trigger by the pulse circuit (404; 806; 1004) in response to said activating step,
**characterized in that** said steps are performed in a tester (102) external to said electronic circuit (106) comprising said unit (108) to be triggered.

2. A method as claimed in Claim 1, wherein the determining step comprises the steps of:
shifting a stimulus to a predetermined first Boundary Scan Test cell (406) of a Boundary Scan Test chain (110), said Boundary Scan Test cell (406) being coupled to a first input (808) of said pulse circuit (404; 806);
applying said stimulus to the first input (808) of the pulse circuit (404; 806) by the predetermined first Boundary Scan Test cell (406);
shifting an enable signal to a predetermined second Boundary Scan Test cell of the Boundary Scan Test chain (110), which second Boundary Scan Test cell is coupled to an enable input (904) of the pulse circuit (404; 806); and
applying the enable signal to the enable input (904) of the pulse circuit (404; 806) by the predetermined second Boundary Scan Test cell, and wherein in the presence of the enable signal the activating step is performed in response to the step of applying said stimulus, and wherein in the absence of the enable signal the stimulus from the first input (808) is passed on in a transparent mode, as an alternative for the pulse trigger.

## Patentansprüche

1. Verfahren zur Beaufschlagung einer zu triggernden Einheit (108) mit einem Triggerimpuls während eines Boundary Scan einer elektronischen Schaltung (106) durch Boundary-Scan-Test-Logik und die elektronischen Schaltung (106) die Einheit (108) umfasst, wobei das Verfahren die folgenden Schritte umfasst:
Bestimmen eines Zustands in der Boundary-Scan-Test-Logik in dem der Triggerimpuls erzeugt werden kann;
Aktivieren einer Impulsschaltung (404; 806; 1004) durch die Boundary-Scan-Test-Logik in Reaktion auf den genannten Zustand; und
Erzeugen des Triggerimpulses durch die Impulsschaltung (404; 806; 1004) in Reaktion auf den genannten aktivierenden Schritt;
**dadurch gekennzeichnet, dass** die genannten Schritte in einem Tester (102) außerhalb der elektronischen Schaltung (106) die der genannten zu triggernden Einheit (108) umfasst durchgeführt werden.

2. Verfahren nach Anspruch 1, wobei der bestimmende Schritt aus den folgenden Schritten besteht:
Schieben eines Stimulus zu einer vorgegebenen ersten Boundary-Scan-Test-Zelle (406) der Boundary-Scan-Test-Kette (110), wobei die genannte Boundary-Scan-Test-Zelle (406) mit einem ersten Eingang (808) der genannten Impulsschaltung (404; 806) verbunden ist;
Weiterleiten des genannten Stimulus an den ersten Eingang (808) der Impulsschaltung (404; 806) durch die vorgegebene erste Boundary-Scan-Test-Zelle (406);
Schieben eines Freigabesignals zu einer vorgegebenen zweiten Boundary-Scan-Test-Zelle der Boundary-Scan-Test-Kette (110), wobei diese zweite Boundary-Scan-Test-Zelle mit einem Freigabeeingang (904) der Impulsschaltung (404; 806) verbunden ist; und
Weiterleiten des Freigabesignals an den Freigabeeingang (904) der Impulsschaltung (404; 806) durch die vorgegebene zweite Boundary-Scan-Test-Zelle, wobei bei Anwesenheit des Freigabesignals der aktivierende Schritt in Reaktion auf den Schritt des Zuführen des genannten Stimulus durchgeführt wird und wobei bei Abwesenheit des Freigabesignals der Stimulus von dem ersten Eingang (808) als Alternative zum Triggerimpuls in einem transparenten Modus weitergeleitet wird.

## Revendications

1. Procédé d'application d'une impulsion de déclenchement à une unité (108) qui doit être déclenché lors d'un balayage de frontière d'un circuit électronique (106) réalisée par la logique de contrôle de balayage de frontière et ce circuit électronique (106) comprend l'unité (108), le procédé comprenant les étapes de :
détermination d'un état dans une logique de contrôle de balayage de frontière dans lequel l'impulsion de déclenchement peut être produite;
activation d'un circuit à impulsions (404; 806; 1004) par la logique de contrôle de balayage de frontière en réaction audit état, et
production de l'impulsion de déclenchement par le circuit à impulsions (404; 806; 1004) en réaction à ladite étape d'activation,
**caractérisé en ce que** lesdites étapes sont exécutées dans un appareil de contrôle (102) extérieur dudit circuit électronique (106) comprenant ladite unité (108) à déclencher.

2. Procédé suivant la revendication 1, dans lequel l'étape de détermination comprend les étapes de :
décalage d'un stimulus vers une première cellule de contrôle de balayage de frontière prédéterminée (406) d'une chaîne de contrôle de balayage de frontière (110), ladite cellule de contrôle de balayage de frontière (406) étant couplée à une première entrée (808) dudit circuit à impulsions (404; 806);
application dudit stimulus à la première entrée (808) du circuit à impulsions (404; 806) par la première cellule de contrôle de balayage de frontière prédéterminée (406);
décalage d'un signal de validation vers une deuxième cellule de contrôle de balayage de frontière prédéterminée de la chaîne de contrôle de balayage de frontière (110), laquelle deuxième cellule de contrôle de balayage de frontière est couplée à une entrée de validation (904) du circuit à impulsions (404; 806), et
application du signal de validation à l'entrée de validation (904) du circuit à impulsions (404; 806) par la deuxième cellule de contrôle de balayage de frontière prédéterminée, et dans lequel, en présence du signal de validation, l'étape d'activation est exécutée en réaction à l'étape d'application dudit stimulus, et dans lequel, en l'absence du signal de validation, le stimulus provenant de la première entrée (808) est transmis en mode transparent, comme variante à l'impulsion de déclenchement.
